# FASCICULE DE BREVET EUROPEEN

(11) **EP 2 896 071 B1**
(45) Date de publication et mention de la délivrance du brevet: **06.06.2018**
(21) Numéro de dépôt: 13766586.5
(22) Date de dépôt: 06.09.2013
(51) Int. Cl.: H01L 31/0224, H01L 31/18

(54) **PROCÉDÉ DE MÉTALLISATION D'UNE CELLULE PHOTOVOLTAÏQUE ET CELLULE PHOTOVOLTAÏQUE AINSI OBTENUE.**
VERFAHREN ZUR PLATTIERUNG EINER FOTOVOLTAIKZELLE UND MIT DIESEM VERFAHREN HERGESTELLTE FOTOVOLTAIKZELLE
METHOD FOR PLATING A PHOTOVOLTAIC CELL AND PHOTOVOLTAIC CELL OBTAINED BY SAID METHOD

(30) Priorité: 11.09.2012 FR 1202414
(43) Date de publication de la demande: 22.07.2015
(73) Titulaire: Commissariat à l'Énergie Atomique et aux Énergies Alternatives, 75015 Paris (FR)
(72) Inventeur: OZANNE, Fabien, 38580 Allevard (FR)
(74) Mandataire: Talbot, Alexandre
(86) Numéro de dépôt international: PCT/FR2013/000230
(87) Numéro de publication internationale: WO 2014/041257

(56) Documents cités:
- EP-A1- 2 184 787
- EP-A2- 2 482 327
- DE-A1-102007 003 682
- BOULORD C ET AL: "Comparison of different electrochemical deposits for contact metallization of silicon solar cells", MATERIALS SCIENCE AND ENGINEERING B, ELSEVIER SEQUOIA, LAUSANNE, CH, vol. 165, no. 1-2, 25 novembre 2009 (2009-11-25), pages 53-56, XP026740970, ISSN: 0921-5107, DOI: 10.1016/J.MSEB.2008.10.039 [extrait le 2008-11-19]
- TOUS L ET AL: "Electroless nickel deposition and silicide formation for advanced front side metallization of industrial silicon solar cells", ENERGY PROCEDIA, vol. 21, 25 octobre 2011 (2011-10-25), - 26 octobre 2011 (2011-10-26), pages 39-46, XP028493616, ISSN: 1876-6102, DOI: 10.1016/J.EGYPRO.2012.05.006 [extrait le 2012-06-15] cité dans la demande
- GUY BEAUCARNE ET AL: "Summary of the Third Workshop on Metallization for Crystalline Silicon Solar Cells", 2 mai 2012 (2012-05-02), ENERGY PROCEDIA, PAGE(S) 2 - 13, XP028493612, ISSN: 1876-6102 [extrait le 2012-06-15] cité dans la demande le document en entier

## Description

### Domaine technique de l'invention

L'invention est relative à un procédé de réalisation d'au moins un contact électrique par dépôt électrochimique d'un matériau électriquement conducteur sur une face d'une cellule photovoltaïque ainsi qu'à une cellule photovoltaïque ainsi obtenue.

### État de la technique

Une des étapes intervenant lors de la réalisation de cellules photovoltaïques est la métallisation des cellules photovoltaïques. Cette métallisation intervient vers la fin du procédé de réalisation des cellules photovoltaïques et elle consiste à déposer sur au moins une des faces de la cellule des contacts métalliques, généralement sous la forme de peignes ou de grille, ou encore sous la forme de quadrillage ou de réseau. Ces contacts métalliques sont destinés à collecter le courant et à interconnecter les cellules entre elles.

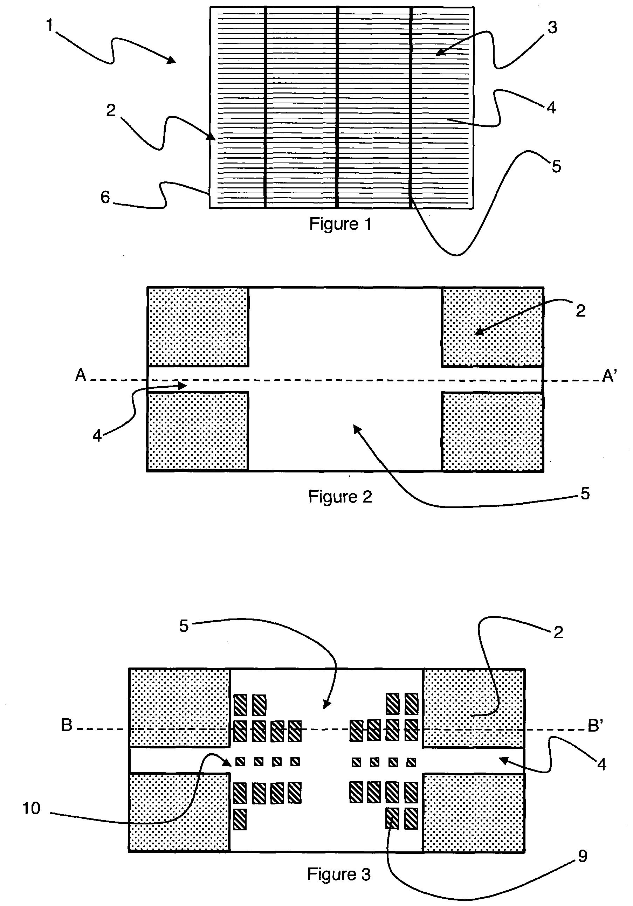

Comme représenté sur les figures 1 et 2, la cellule photovoltaïque 1 comporte au moins une face principale 2 recouverte d'un contact électrique sous forme d'une grille 3 composée de premières lignes 4 et de deuxièmes lignes 5 aussi appelées bus-barres. Les bus-barres 5 sont plus larges que les premières lignes 4 et elles sont perpendiculaires aux premières lignes 4. Tous les bus-barres 5 sont parallèles entre eux et toutes les premières lignes 4 sont parallèles entre elles.

La principale technique de métallisation est la sérigraphie et les contacts métalliques sont le plus souvent en argent.
Cette technique présente toutefois un certain nombre de limitations comme, par exemple, une résistivité élevée du contact électrique et une largeur importante des lignes. La largeur des lignes est généralement de l'ordre de 70 à 120µm, ce qui provoque un taux d'ombre conséquent sur la face de la cellule diminuant ainsi le rendement de la cellule.

De plus, comme présenté dans le document « International Technology Roadmap for Photovoltaics (ITRPV) » (Third Edition March 2012), un des objectifs dans le domaine solaire, pour les années futures, est de remplacer l'argent par du cuivre ou tout autre métal moins coûteux.

Les documents « Control of Nickel silicide formation using porous silicon in direct plating concepts for silicon solar cell front side metallization », « Electroless nickel deposition and silicide formation for advanced front side metallization of industrial silicon solar cells » et « 21.4% Silicon Solar Cells with Fully Plated Nickel - Copper Metallization » du « 3rd Workshop on Metallization for Crystalline Silicon Solar Cells » (2011) présentent des méthodes de métallisation par voie électrochimique. Ces méthodes connaissent actuellement un intérêt croissant car elles présentent de nombreux avantages : meilleures performances électriques et diminution du coût de fabrication par rapport à la sérigraphie. Les techniques électrochimiques permettent notamment de remplacer l'argent, couramment utilisé en sérigraphie, par du nickel ou du cuivre par exemple.

Cependant, les méthodes de formation des contacts métalliques par voie électrochimique conduisent à une diminution de l'épaisseur des contacts et donc à augmentation de la résistance linéique, dite résistance « de ligne ».

### Objet de l'invention

L'invention a pour but de remédier aux inconvénients de l'art antérieur et, en particulier, de proposer un procédé de réalisation d'au moins un contact électrique par dépôt électrochimique, simple, robuste, reproductible et permettant d'avoir une diminution de la résistance de ligne.

L'invention a également pour but de proposer une cellule photovoltaïque qui présente des performances électriques améliorées.

On tend vers ces objets par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, la face principale d'une cellule photovoltaïque, la face principale étant recouverte par une grille,
- la figure 2 représente, de manière schématique, l'intersection de deux lignes métalliques de différentes largeurs sur la face principale d'un substrat,
- les figures 3 et 5 représentent, de manière schématique et en vue de dessus, une cellule photovoltaïque selon un mode de réalisation,
- la figure 4 représente, de manière schématique et en coupe selon le plan AA' de la figure 2, l'intersection de deux lignes métalliques sur la face principale d'un substrat,
- les figures 6 à 9 représentent, de manière schématique et en coupe selon le plan BB' de la figure 3, une cellule photovoltaïque selon un premier mode particulier de réalisation, lors de différentes étapes du procédé de réalisation de la cellule photovoltaïque,
- les figures 10 à 12 représentent, de manière schématique et en coupe selon le plan BB' de la figure 3, une cellule photovoltaïque selon un deuxième mode particulier de réalisation, lors de différentes étapes du procédé de réalisation de la cellule photovoltaïque,
- les figures 13 à 15 représentent de manière schématique et en coupe selon le plan BB' de la figure 3, une cellule photovoltaïque selon un troisième mode particulier de réalisation de la cellule photovoltaïque.

### Description d'un mode de réalisation préférentiel de l'invention

Le procédé de réalisation concerne la fabrication d'au moins un contact électrique 8, par dépôt électrochimique, d'un matériau électriquement conducteur sur une face d'une cellule photovoltaïque 1, ledit contact étant formé de première 4 et deuxième 5 lignes connectées entre elles, la deuxième ligne 5 présentant une largeur supérieure à la largeur de la première ligne 4.

Par largeur, on entend l'une des deux dimensions surfaciques de la ligne. La largeur correspond à la dimension la plus étroite de la surface. La dimension la plus longue correspond à la longueur.

Par connectée entre elles, on entend que les deux lignes se touchent, les deux lignes font partie du même motif. Les lignes sont connectées électriquement entre elles. Elles forment un même contact, c'est-à-dire qu'un courant peut passer d'une ligne à l'autre. Les lignes ne sont pas isolées électriquement l'une de l'autre par une zone totalement isolante.
La zone de connexion entre les lignes est appelée intersection. Les deux lignes sont connectées par exemple sous la forme d'un té ou d'une croix. Préférentiellement, les deux lignes sont perpendiculaires ou sensiblement perpendiculaires entre elles. Les deux lignes sont définies dans un même plan parallèle à la surface du substrat.

Selon un mode de réalisation particulier, le fond des deux lignes est formé par la surface du substrat.

Avantageusement, les lignes sont formées en un seul et même dépôt électrochimique. Elles ne sont pas superposées l'une sur l'autre, elles sont sensiblement au même niveau sur le substrat.

La largeur de la première ligne 4 est, préférentiellement, comprise entre 5µm et 100µm. La largeur de la deuxième ligne 5 est, préférentiellement, comprise entre 0,1 mm et 1,5mm.

Comme représenté sur la figure 3, le procédé comporte, avant le dépôt électrochimique, une étape de formation d'au moins une zone 9 présentant une conductivité électrique inférieure à la conductivité électrique du matériau électriquement conducteur destiné à former le contact électrique 8, sur une partie de la face de la cellule photovoltaïque, destinée à être couplée électriquement avec la deuxième ligne 5, au niveau de son intersection 10 avec la première ligne 4, c'est-à-dire à proximité de l'intersection 10 des lignes. La formation de la zone 9, à l'intersection 10 des lignes, permet de diminuer localement la conductivité et donc de modifier localement la vitesse du dépôt électrochimique. Ceci est destiné à obtenir des hauteurs de lignes uniformes à proximité des régions métallisées de la cellule photovoltaïque présentant une grande surface par rapport à la largeur de la première ligne.

Pour réaliser le procédé de métallisation d'au moins une face de la cellule photovoltaïque 1, un substrat 6, avantageusement, cristallin, c'est-à-dire mono-cristallin ou polycristallin, est utilisé. Le substrat 6 est formé par un matériau semi-conducteur, par exemple, un matériau du type IV, comme Si, Ge, un alliage de ces matériaux, un matériau de type III-V ou II-VI. Le substrat 6 comporte une jonction photovoltaïque en matériau semi-conducteur. La jonction photovoltaïque du substrat 6 est par exemple une jonction de type p/n et est réalisée dans un matériau semi-conducteur tel que le silicium. Il est également envisageable d'utiliser un substrat polymère comportant une jonction photovoltaïque.

La métallisation est réalisée sur au moins une des faces principales 2 du substrat 6, c'est-à-dire que les première 4 et deuxième 5 lignes sont disposées sur au moins une des faces principales 2 du substrat 6.

Par face principale, on entend que le substrat de la cellule photovoltaïque 1 comporte deux faces principales opposées, ce sont les faces de plus grandes dimensions. Au moins une des faces principales est une face active. Quand une seule des faces principales du substrat 6 de la cellule photovoltaïque 1 est active, il s'agit de la face exposée au rayonnement électromagnétique incident, ladite face est généralement appelée face avant.

La cellule photovoltaïque 1 peut être monofaciale ou bifaciale. Dans le cas d'une cellule photovoltaïque monofaciale, la métallisation est, avantageusement, réalisée uniquement sur une des faces, de préférence, la face dite active, généralement sur la face avant. Dans le cas d'une cellule photovoltaïque bifaciale, la métallisation peut être réalisée sur les deux faces principales de la cellule photovoltaïque.

Le substrat 6 peut aussi comporter, selon un mode de réalisation particulier, une couche antireflet. La couche antireflet peut être par exemple constituée de nitrure de silicium, d'oxyde de silicium ou d'oxyde transparent conducteur.

La face avant du substrat 6 peut éventuellement être texturée pour améliorer l'absorption du rayonnement incident.

Préférentiellement, pour réaliser au moins un contact électrique 8, le procédé comporte, avant l'étape de dépôt électrochimique, une étape de formation d'un masque 7, sur ladite face de la cellule photovoltaïque. Le masque est destiné à délimiter, lors de l'étape de dépôt électrochimique, la position du contact électrique. Il comporte en particulier des ouvertures formant un motif correspondant à celui du contact électrique. Ainsi, le matériau électriquement conducteur est déposé, à travers ledit masque 7 lors du dépôt électrochimique, afin de former le contact électrique 8 sous la forme de première 4 et deuxième 5 lignes.

Ainsi, le masque 7 recouvre la face principale 2 et il définit un motif dépourvu de matériau.

Préférentiellement, le masque 7 est réalisé en un matériau électriquement isolant. Par matériau électriquement isolant, on entend un matériau ne conduisant pas ou très peu le courant électrique, c'est-à-dire ayant une conductivité électrique proche de zéro.

Il s'agit préférentiellement d'un polymère et, plus particulièrement, d'une résine telle qu'une résine organique photosensible ou sensible au rayonnement électronique, celle-ci étant insolée de manière à former les motifs du masque 7.

Selon un autre mode de réalisation, le masque 7 peut être en oxyde de silicium ou en nitrure de silicium, par exemple SiN ou SiO₂.

Le masque 7 est déposé sur la face principale 2 du substrat 6 par toute technique adaptée. Par exemple, le masque 7 est formé par photolithographie, par sérigraphie ou par dépôt d'une couche en matériau isolant électriquement, sur la face de la cellule photovoltaïque, et par application d'un faisceau laser, ou gravure laser (« patterning » en anglais), à la surface de ladite couche pour former les ouvertures dans la couche.

Le masque 7 pourrait aussi être élaboré à partir d'un matériau de plus forte résistivité que le matériau sur lequel il est formé, celui-ci étant alors faiblement conducteur. Le matériau électriquement conducteur peut alors se déposer à la fois sur la surface laissée libre par les ouvertures du masque et sur celui-ci. Le masque 7 et éventuellement la partie de matériau électriquement conducteur le recouvrant peuvent être retirés par gravure une fois le dépôt électrochimique réalisé, afin de ne conserver le matériau électriquement conducteur, déposé uniquement, dans les ouvertures du masque.

Par ailleurs, comme indiqué précédemment, le dépôt électrochimique du matériau électrique conducteur destiné à former le contact électrique est précédé d'une étape de formation d'au moins une zone 9 en un matériau présentant une conductivité électrique inférieure à la conductivité électrique du matériau électriquement conducteur. La zone 9 est formée sur une partie de la face de la cellule photovoltaïque, destinée à être couplée électriquement avec la deuxième ligne 5, au niveau de son intersection 10 avec la première ligne.

Préférentiellement, la zone 9 est élaborée en un matériau plus résistif que le matériau de la surface sur laquelle il est déposé : il s'agit d'un matériau ayant une conductivité inférieure à celle du matériau sur lequel il est déposé.

La présence de la zone 9, à l'intersection 10 des lignes, permet de diminuer localement la conductivité et donc de modifier localement la vitesse du dépôt électrochimique.

Ainsi, la partie de la face de la cellule photovoltaïque destinée à être couplée électriquement avec la deuxième ligne comporte alors avant le dépôt électrochimique, des régions de conductivités électriques différentes, la conductivité de la zone 9 étant strictement inférieure à la conductivité électrique du reste de ladite partie de la face. Ceci permet alors de former respectivement deux types différents de couplage électrique dans ladite partie de la face de la cellule, avec le bain électrochimique.

Ainsi, le matériau électriquement conducteur destiné à former le contact électrique 8 se déposera, lors du dépôt électrochimique, préférentiellement et plus rapidement sur la région ayant la conductivité électrique supérieure.

Ceci permet de maîtriser localement la vitesse de croissance du contact électrique 8, au niveau de l'intersection des lignes 4 et 5, lors du dépôt électrochimique. Il est aussi possible de maîtriser le lieu où se déposera préférentiellement le matériau électriquement conducteur du contact électrique 8 et donc de maîtriser localement l'épaisseur du contact électrique 8.

Dans le cas où la zone 9 n'est pas complètement isolante, le matériau électriquement conducteur peut se déposer sur ladite zone 9 à une vitesse limitée par rapport à la vitesse de dépôt du matériau électriquement conducteur sur le reste de la face de la cellule photovoltaïque, puisque la conduction des électrons intervenant dans le dépôt électrochimique est plus difficile.

La zone 9 et la portion de matériau électriquement conducteur disposé sur la zone 9 peuvent ensuite être retirées par gravure par exemple.

Selon un mode de réalisation préférentiel, la zone 9 est électriquement isolante. Ainsi, le matériau constituant ladite zone 9 est un matériau électriquement isolant : sa conductivité électrique est nulle ou proche de zéro, de manière à modifier de manière importante la surface active de la deuxième ligne 5 au niveau de l'intersection 10 des lignes et à empêcher le dépôt électrochimique au niveau de la zone 9 : le couplage électrique entre la partie de la face de la cellule photovoltaïque, au niveau de la zone 9, et le bain électrochimique est alors nul et il n'y a pas de dépôt métallique sur la zone 9, lors de l'étape de dépôt électrochimique.

Avantageusement, dans le cas d'une zone 9 électriquement isolante, la surface active sera la même tout au long du dépôt et le procédé sera mieux maîtrisé. La présence de la zone 9 isolante permet de modifier la surface électriquement active de la cellule photovoltaïque destinée à être recouverte par la deuxième ligne 5 lors du dépôt électrochimique. Par surface électriquement active, on entend la surface disponible pour le dépôt électrochimique, c'est-à-dire la surface qui est en contact avec le bain électrolytique lors du dépôt, pour le transfert des électrons. Le bain électrolytique contient les ions métalliques en solution qui serviront à la formation du contact électrique 8. En réduisant la surface électriquement active, les conditions de dépôt sont modifiées : la densité de courant est augmentée sur la deuxième ligne 5 puisque le courant total utilisé lors du dépôt est réparti sur une surface électriquement active réduite.

De plus, étant donné que la zone 9 est ménagée sur la ligne de plus grande largeur, c'est-à-dire sur la deuxième ligne 5, la différence de densité de courant entre les lignes au niveau de leur intersection 10 est minimisée. L'épaisseur du contact électrique 8 sera plus homogène tant au niveau de l'intersection 10 des lignes 4 et 5 que sur la longueur de la ligne 5 de deuxième largeur. Ainsi, le goulot d'étranglement en termes de résistance de ligne est amoindri et les performances de la cellule photovoltaïque 1 sont améliorées.

Le procédé de métallisation permet d'obtenir des contacts électriquement plus homogènes entre les lignes 4 et 5 par rapport à un procédé comportant un dépôt électrochimique sur un substrat ne comportant pas de zone 9.

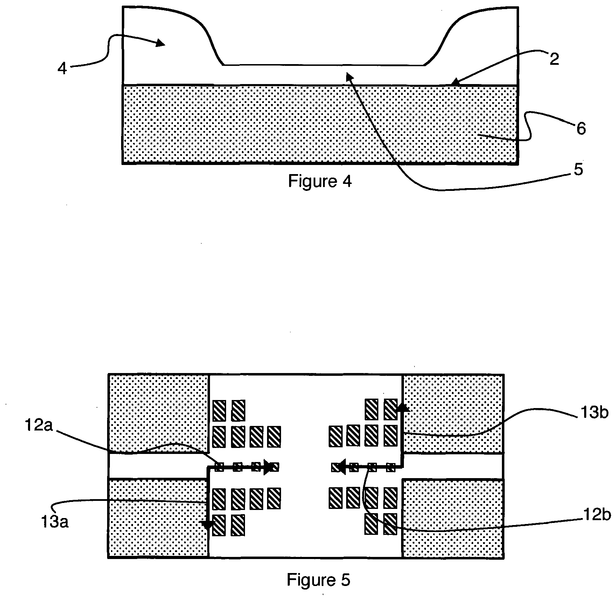

En effet, comme représenté sur la figure 4, sans la présence de la zone 9, l'épaisseur du contact électrique 8 sur la ligne 5 de deuxième largeur est plus fine que l'épaisseur des lignes 4 de première largeur. De plus, les lignes 4 de première largeur présentent une épaisseur non uniforme : proche de la ligne 5 de deuxième largeur, la ligne 4 de première largeur est plus fine, ce qui entraîne la formation d'un goulot d'étranglement en termes de résistance de ligne, diminuant ainsi les performances de la cellule photovoltaïque. Dans le cas du procédé comportant une zone 9, les performances de la cellule photovoltaïque sont améliorées car la résistance de ligne au niveau des contacts est plus faible.

Par résistance de ligne, on entend la résistance propre à l'épaisseur de la ligne.

Par goulot d'étranglement, on entend une section plus étroite pour le passage du courant. Par exemple, il peut s'agir d'une épaisseur de ligne plus faible, ce qui provoque, localement, une augmentation de la résistance et une diminution des performances de la cellule photovoltaïque 1. De plus, les largeurs de ligne peuvent être de plus en plus fines et le coût des cellules est réduit.

Ainsi, la zone 9 est formée par un matériau électriquement isolant, tel que le nitrure de silicium, l'oxyde de silicium ou les résines organiques photosensibles ou non.

La zone 9 est, avantageusement, élaborée en même temps que le masque 7 à partir du même matériau isolant : la zone 9 est constituée par une partie dudit masque 7. Il s'agit, par exemple, d'une résine déposée sur le substrat 6, ladite résine étant insolée de manière à former les motifs du masque 7 et de manière à former au moins une zone 9 isolante.

Préférentiellement, la zone 9 est sous la forme d'un pilier ayant, en particulier, une section carrée, rectangulaire ou circulaire. Ces formes de base sont avantageusement plus faciles à réaliser que des formes plus complexes.

Préférentiellement, la base du pilier est de forme circulaire afin de diminuer les effets de pointe.

La surface de la base de la zone 9 est comprise entre 0,1w² et 10w², w étant la largeur de la première ligne, c'est-à-dire entre 0,1 fois et 10 fois la largeur au carré de la première ligne 4.

Comme représenté sur les figures 3 et 5, préférentiellement, la deuxième ligne 5 comporte plusieurs zones 9. Ainsi, différentes dispositions et différentes densités surfaciques en zones 9 sur la deuxième ligne 5 peuvent être envisagées. Il est ainsi plus facile de maîtriser localement l'épaisseur du contact électrique 8.

Comme représenté sur la figure 5, les lignes de première 4 et deuxième 5 largeurs définissent avantageusement un repère orthonormé (O, x, y), O étant l'origine du repère et correspond au point situé au milieu de la première ligne 4 et à l'intersection de la première ligne 4 et de la deuxième ligne 5 dans le prolongement d'une face latérale. L'axe x 12a et 12b est parallèle à l'axe longitudinal de la première ligne 4 et passe en son milieu. Il part de l'intersection 10 entre les lignes et il est dirigé vers l'intérieur de la deuxième ligne 5. L'axe y 13a et 13b est parallèle à l'axe longitudinal de la deuxième ligne 5 et est situé sur le bord de la deuxième ligne 5. Comme représenté sur la figure 5, l'axe y 13a et 13b peut être orienté dans deux directions différentes. Les axes x et y sont parallèles à la face principale 2 de la cellule photovoltaïque 1.

La zone ou les zones 9 sont, préférentiellement, disposées dans un périmètre délimité par les points de coordonnées (0, -10w), (0, 10w), (10w, 10w) et (10w, - 10w), le point de coordonnées (0, 0) correspondant au point situé au milieu de la première ligne 4 et à l'intersection de la première ligne 4 et de la deuxième ligne 5, w correspondant à la largeur de la première ligne 4 selon l'axe y. Ladite zone 9 est située à proximité de l'intersection 10 des lignes, et plus particulièrement, dans le périmètre décrit ci-dessus.

Ainsi la ou les zones 9 ont un effet remarquable sur l'épaisseur des lignes au niveau de l'intersection 10. Des zones 9 pourraient, cependant, être disposées hors du périmètre pour contrôler l'épaisseur de la deuxième ligne 5 sur une plus grande surface.

Les zones 9 peuvent être réparties dans le périmètre de manière asymétrique ou symétrique. La symétrie est définie, par exemple, par rapport à un plan, perpendiculaire à la surface supportant les lignes, disposé au milieu de la ligne de première largeur 4 et/ou par rapport à un plan disposé au milieu de la ligne de deuxième largeur 5. Les zones sont disposées de manière contrôlée afin de maîtriser le courant surfacique et donc l'épaisseur obtenue à la jonction des lignes de première et deuxième largeurs. Ainsi, la hauteur du contact électrique 8 est plus uniforme à proximité des intersections où la surface métallisée est grande par rapport à la largeur de la ligne.

La surface totale occupée par les deuxièmes zones 9 dépend de la largeur des première 4 et deuxième 5 lignes. La surface des zones 9 et leur répartition permettent de maîtriser l'épaisseur du contact électrique 8 et influencent également les propriétés électriques des lignes en terme de résistance par exemple. Ainsi, si les zones 9 sont réparties pour former une zone trop dense et/ou si la surface occupée est trop grande, la résistivité des lignes 5 va augmenter et donc le rendement cellule va diminuer. En revanche, si la densité est trop faible et la surface trop petite, la surface active lors du dépôt ne diminuera pas suffisamment et les lignes 4 présenteront des goulots d'étranglement importants, ce qui augmentera la résistance de lignes. Avantageusement, une surface comprise entre 0,1w² et 10w² permet d'obtenir des performances électriques intéressantes.

L'épaisseur du contact électrique 8 est, avantageusement, inférieure à l'épaisseur du masque 7. L'épaisseur du contact électrique 8 est, préférentiellement, comprise entre 2µm et 100µm et, de préférence, entre 10µm et 40µm.

Le contact électrique 8 est déposé par dépôt électrochimique (ECD pour « electrochemical deposition » en anglais). Le contact électrique 8 peut être par exemple en nickel, en argent, en cuivre, en étain ou un de leurs alliages. Selon un mode de réalisation préférentiel, le contact électrique 8 est en cuivre. Avantageusement, l'utilisation du cuivre plutôt que de l'argent, par exemple, permet de diminuer les coûts d'élaboration de la cellule photovoltaïque 1.
Dans le cas de l'utilisation d'un contact électrique 8 en cuivre et d'une cellule photovoltaïque 1 en silicium, une couche barrière sera avantageusement disposée entre ledit contact électrique 8 et le silicium de la cellule photovoltaïque 1 afin d'éviter la diffusion du cuivre dans le silicium et donc la contamination du silicium.

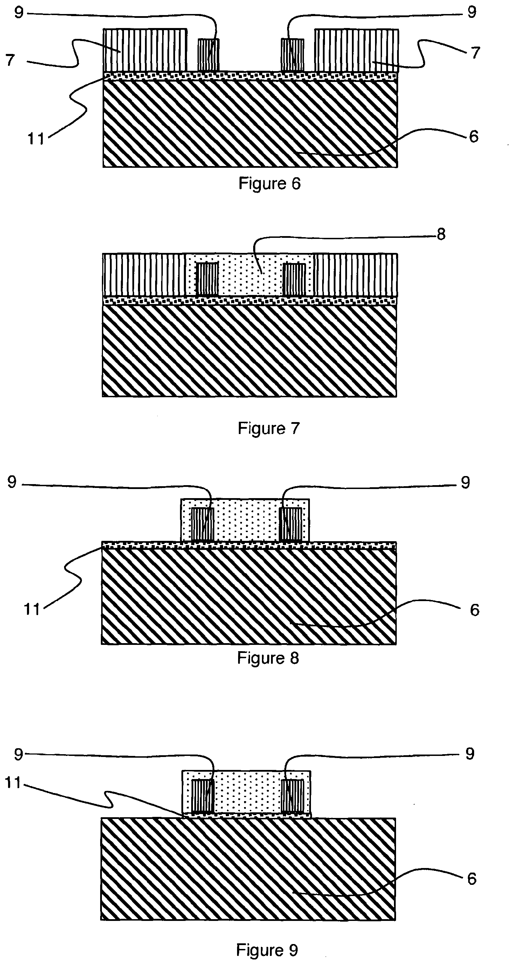

Comme représenté sur les figures 6 à 12, le procédé de réalisation de la cellule photovoltaïque 1 comporte, si le substrat 6 n'est pas assez électriquement conducteur pour un dépôt aisé du contact électrique 8 par voie électrochimique, par exemple dans le cas où la face avant de la cellule photovoltaïque 1 est électriquement isolante, une étape de dépôt d'une couche métallique 11 électriquement conductrice sur le substrat 6, avant le dépôt électrochimique du contact électrique 8 pour activer le dépôt électrochimique. Cette couche métallique 11 correspond à une couche dite couche d'activation aussi appelée « seed layer » en anglais.

De même, si la face de la cellule photovoltaïque est isolante électriquement, une étape de dépôt d'une couche métallique 11 est réalisée avant le dépôt électrochimique pour activer le dépôt électrochimique.

Selon un autre mode de réalisation particulier, la face de la cellule photovoltaïque peut être électriquement conductrice, mais le contact électrique 8 adhère peu sur la face de la cellule : une couche métallique 11 intermédiaire peut alors être déposée sur la face de la cellule avant le dépôt du contact électrique 8 afin de faciliter le dépôt dudit contact.

Cette étape est réalisée préférentiellement par dépôt auto-catalytique (« electroless » en anglais). Le dépôt auto-catalytique est réalisé par voie humide sans utiliser de courant électrique, il est basé sur la présence d'un agent réducteur en solution pour réduire des ions métalliques. Un tel dépôt peut ainsi être formé sur une surface électriquement isolante. Eventuellement, il peut aussi être réalisé sur une surface électriquement conductrice.

La couche métallique 11 déposée par dépôt auto-catalytique est, par exemple, en nickel ou en cobalt.

Selon un autre mode de réalisation particulier, la couche métallique 11 est déposée par pulvérisation ou par jet d'encre et peut être, par exemple, en cuivre, en argent ou en nickel.

Dans le cas de l'utilisation de contacts électriques en cuivre et d'une cellule photovoltaïque 1 en silicium, la couche métallique 11 peut jouer, avantageusement, le rôle de couche barrière pour éviter la diffusion du cuivre dans le silicium et donc la contamination du silicium.

Les figures 6 à 9 représentent un premier mode de réalisation particulier de la cellule photovoltaïque 1. Dans ce mode de réalisation, la couche métallique 11 est réalisée avant la formation du masque 7 (figure 6). Avantageusement, la couche métallique 11 est formée sur la totalité de la face de la cellule photovoltaïque 1 avant la formation du masque 7.

La formation du masque 7 et la formation de la ou des zones 9 peuvent être réalisées simultanément ou l'une après l'autre.
Préférentiellement, la zone 9 est formée en même temps que le masque, ce qui permet d'auto-aligner les zones 9 avec le dessin de la ligne 5.

Comme représenté sur la figure 7, le contact électrique 8 est ensuite déposé sur la couche métallique 11 à travers le masque 7. Finalement, comme représenté sur la figure 8, une fois le dépôt électrochimique réalisé le masque 7 est avantageusement retiré.
Le masque 7 peut être retiré par toute technique adaptée. Il s'agit par exemple de gravure chimique ou de plasma O₂.
Puis la partie de la couche métallique 11, non recouverte par le contact électrique 8, est préférentiellement retirée (figure 9).

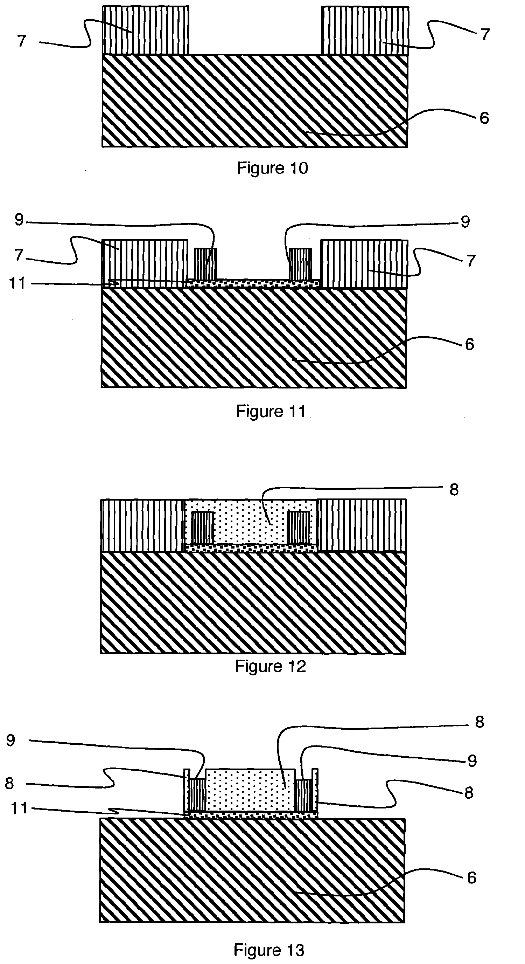

Les figures 10 à 12 représentent un autre mode de réalisation, dans lequel la couche métallique 11 est formée à la suite de l'étape de formation du masque 7 dans les ouvertures du masque 7 (figures 10 et 11). La formation de la ou des zones 9 de première résistivité est réalisée après le dépôt de la couche métallique 11 (figure 11). Le contact électrique 8 est ensuite déposé sur la couche métallique 11 à travers le masque 7 (figure 12). Le masque 7 est ensuite retiré.

Selon un autre mode de réalisation, la couche métallique 11 déposée sur le substrat, comporte des ouvertures, c'est-à-dire des trous traversant, de manière à laisser accessible une partie du substrat 6. Avantageusement, dans le cas d'un substrat 6 isolant, ces ouvertures dans la couche métallique 11 représentent les deuxièmes zones 9.

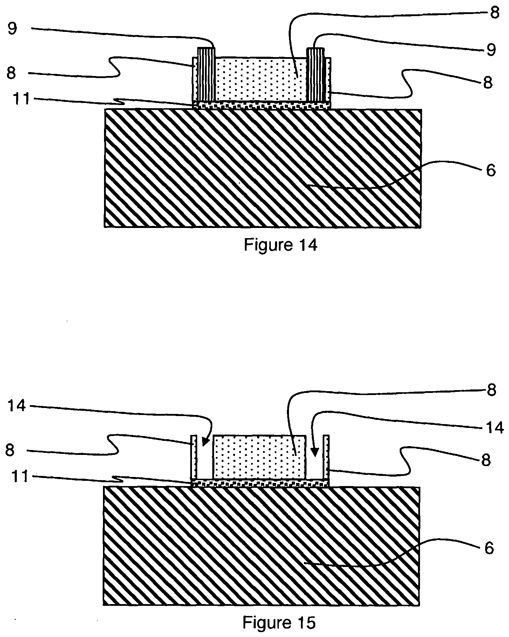

Sur les figures 7 à 9 et 12, les zones 9 sont entièrement recouvertes par le matériau électriquement conducteur du contact électrique 8. Cependant, comme représenté sur les figures 13 à 15, la zone 9 peut avoir une surface libre, c'est-à-dire qu'elle n'est pas recouverte par le matériau électriquement conducteur du contact électrique 8. Par exemple, il peut s'agir du cas où l'épaisseur du contact électrique 8 est légèrement supérieure à la zone 9 (figure 13) ou encore dans le cas où l'épaisseur du contact électrique 8 est inférieure (figure 14) ou égale à celle de la zone 9.

La zone 9 peut être retirée, par exemple par gravure chimique ou par plasma O₂. La zone 9 est alors dépourvue de matériau. Comme représenté sur la figure 15, la zone 9 est représentée par un trou 14. Par trou, on entend une cavité vide. Avantageusement, ce mode de réalisation permet de ne pas avoir de matériaux isolants tels que les polymères, SiN ou SiO₂, dans les zones métallisées.

Les contacts électriques 8 ainsi obtenus sont électriquement continus mais « ajourés » par les zones 9. Ainsi, les contacts électriques 8 comportent des trous 14. Cependant, la densité et la disposition des trous 14 sont réalisées de manière à ce que les contacts électriques présentent de bonnes propriétés de conduction électrique.

Sur les figures 6 à 15, seulement deux zones 9 ont été représentées afin de rendre les schémas plus clairs. Cependant, plusieurs zones 9 de seconde résistivité peuvent être utilisées.

Les modes de réalisation décrits précédemment peuvent être réalisés seuls ou en combinaison.

Plusieurs zones 9 peuvent être disposées au niveau de l'intersection 10 des première 4 et deuxième 5 lignes. Les zones 9 peuvent être de différentes formes et avoir des surfaces différentes.

Avantageusement, le masque 7 comporte plusieurs lignes 4 de première largeur et plusieurs lignes 5 de deuxième largeur, de manière à réaliser un motif en forme de peigne et plus particulièrement un motif en forme de grille. Ainsi, un seul masque peut être utilisé pour réaliser la métallisation sous forme de grille sur une des faces 2 de la cellule photovoltaïque 1 ou sur les deux faces de la cellule photovoltaïque 1.

La grille métallique obtenue en face avant d'une cellule photovoltaïque 1 absorbe une partie du rayonnement incident, ce qui limite le courant photo-généré et diminue le rendement de la cellule. Avantageusement, la grille obtenue selon l'invention présente des lignes moins larges que celles des grilles obtenues classiquement. Ainsi, le rendement d'une cellule photovoltaïque 1 obtenue selon l'invention est amélioré.

Le procédé est applicable pour tout type de cellules photovoltaïques 1 utilisant une métallisation par voie électrochimique.

Une cellule photovoltaïque 1 comprend classiquement :
- un substrat 6 comportant :
   ∘ une jonction photovoltaïque,
   ∘ au moins une face principale 2,
   ∘ au moins un contact électrique 8 couplé électriquement avec la face principale 2 du substrat, ledit contact électrique 8 étant sous la forme d'une première ligne 4 de première largeur et d'une deuxième ligne 5 de deuxième largeur supérieure à la première largeur, la première ligne 4 étant connectée à la deuxième ligne 5.

La cellule photovoltaïque 1, obtenue par les différents procédés de réalisation précédemment décrits, est alors munie sur au moins une face d'un contact électrique en matériau électriquement conducteur formé de première et deuxième lignes 4 connectées entre elles. La deuxième ligne présente une largeur supérieure à la largeur de la première ligne. De plus, elle comporte, au moins dans une partie de son épaisseur et au niveau de son intersection 10 avec une première ligne, une zone 9 ayant une conductivité inférieure à celle du matériau électriquement conducteur formant le contact électrique. En particulier, la zone 9 est en contact avec. la face de la cellule photovoltaïque. La zone 9 peut être ainsi être entièrement recouverte par le matériau électriquement conducteur du contact électrique ou alors elle peut être partiellement recouverte ou encore elle peut être non recouverte par celui-ci.

De plus, dans la cellule photovoltaïque 1, l'épaisseur du contact électrique 8 de la deuxième ligne 5 augmente en direction de l'intersection 10 entre les première 4 et deuxième 5 lignes. Ainsi, même si le contact électrique 8 comporte des zones 9, lesdites zones 9 étant vides ou pleines, l'épaisseur du contact électrique 8, en dehors de ces zones 9, augmente vers l'intersection 10 des lignes.

La zone 9 est, préférentiellement, électriquement isolante afin d'avoir un effet important sur la modulation d'épaisseur du contact électrique 8 au niveau de l'intersection des lignes.

Selon un autre mode de réalisation préférentiel, la zone 9 est en matériau électriquement isolant, en particulier du nitrure de silicium, de l'oxyde de silicium ou une résine organique photosensible.

Selon un autre mode de réalisation préférentiel, la zone 9 peut être enlevée après formation du contact électrique 8, le contact électrique 8 comporte alors des trous 14, c'est-à-dire des cavités vides : la zone 9 est dépourvue de matériau. La zone 9 est alors représentative d'une cavité remplie d'air ou d'un autre gaz.

De ce fait, selon les modes de réalisation, la zone de deuxième résistivité est une zone plus mince de la ligne 5, un trou dans le matériau électriquement conducteur du contact électrique ou un autre matériau entouré par le matériau électriquement conducteur du contact électrique 8.

Les première 4 et deuxième 5 lignes sont avantageusement perpendiculaires entre elles et définissent un té ou une croix. Il est également possible de former un L. De manière plus générale, le passage d'une première ligne 4 vers une deuxième lige 5 comporte l'utilisation d'une ou plusieurs zones 9 qui définissent après formation du contact électrique une ou plusieurs zones de deuxième résistivité.

La zone 9 est disposée dans un périmètre délimité par les points de coordonnées (0, -10w), (0, 10w), (10w, 10w) et (10w, -10w), le point de coordonnées (0, 0) correspondant au point situé au milieu de la première ligne 4 et à l'intersection 10 de la première 4 ligne et de la deuxième 5 ligne et w correspondant à la largeur de la première ligne 4.
La surface de la zone 9 est comprise entre 0,1 fois et 10 fois la largeur au carré de la première ligne 4.

Le matériau électriquement conducteur formant le contact électrique 8 est en argent, en cuivre, en nickel, en étain ou un de leurs alliages.
Préférentiellement, le contact électrique 8 est en argent ou en cuivre afin d'avoir une conductivité plus élevée.

La largeur de la première ligne 4 est, avantageusement, comprise entre 5µm et 100µm et la largeur de la deuxième ligne 5 est, avantageusement, comprise entre 0,1 mm et 1,5mm afin d'avoir un taux d'ombre réduit.

## Revendications

1. Procédé de réalisation d'au moins un contact électrique (8) par dépôt électrochimique d'un matériau électriquement conducteur sur une face d'une cellule photovoltaïque (1), ledit contact étant formé de première (4) et deuxième (5) lignes connectées entre elles, la deuxième ligne (5) présentant une largeur supérieure à la largeur de la première ligne (4),
**caractérisé en ce qu'**il comporte, avant le dépôt électrochimique, une étape de formation d'au moins une zone (9) présentant une conductivité électrique inférieure à la conductivité électrique du matériau électriquement conducteur, sur une partie de la face de la cellule photovoltaïque (1), destinée à être couplée électriquement avec la deuxième ligne (5), au niveau de son intersection (10) avec la première ligne (4).

2. Procédé selon la revendication 1, **caractérisé en ce que** la zone (9) est formée par un matériau électriquement isolant, tel que le nitrure de silicium, l'oxyde de silicium ou les résines organiques par exemple photosensibles.

3. Procédé selon l'une des revendications 1 et 2, **caractérisé en ce que** la zone (9) est sous la forme d'un pilier ayant, en particulier, une section carrée, rectangulaire ou circulaire.

4. Procédé selon l'une quelconque des revendications 1 à 3, **caractérisé en ce qu'**il comporte, avant l'étape de dépôt électrochimique, une étape de formation d'un masque (7) en matériau isolant électriquement, tel que le nitrure de silicium, l'oxyde de silicium ou les résines organiques par exemple photosensibles, sur ladite face de la cellule photovoltaïque, ledit masque comprenant des ouvertures formant un motif correspondant à celui du contact électrique.

5. Procédé selon la revendication 4, **caractérisé en ce que** le masque est formé par photolithographie, par sérigraphie ou par dépôt d'une couche en matériau isolant électriquement, sur la face de la cellule photovoltaïque et application d'un faisceau laser à la surface de ladite couche pour former les ouvertures dans la couche.

6. Procédé selon l'une des revendications 4 et 5, **caractérisé en ce que** le masque (7) est retiré une fois le dépôt électrochimique réalisé.

7. Procédé selon l'une quelconque des revendications 4 à 6, **caractérisé en ce que** la zone (9) est constituée par une partie dudit masque (7).

8. Procédé selon l'une quelconque des revendications 4 à 7, **caractérisé en ce qu'**une étape de dépôt d'une couche métallique (11) est réalisée avant le dépôt électrochimique pour activer le dépôt électrochimique.

9. Procédé selon la revendication 8, **caractérisé en ce que** la couche métallique (11) est formée sur la totalité de la face de la cellule photovoltaïque, avant la formation du masque (7).

10. Procédé selon la revendication 8 **caractérisé en ce que** la couche métallique (11) est formée à la suite de l'étape de formation du masque (7) dans les ouvertures dudit masque (7).

11. Cellule photovoltaïque (1) munie sur au moins une face d'un contact électrique (8) en matériau électriquement conducteur et formé de première (4) et deuxième (5) lignes connectées entre elles, la deuxième ligne (5) présentant une largeur supérieure à la largeur de la première ligne (4),
**caractérisée en ce que** la deuxième ligne (5) comporte, au moins dans une partie de son épaisseur et au niveau de l'intersection (10) des lignes, une zone (9) ayant une conductivité inférieure à celle du matériau électriquement conducteur.

12. Cellule photovoltaïque selon la revendication 11, **caractérisée en ce que** la zone (9) est en matériau électriquement isolant, en particulier du nitrure de silicium, de l'oxyde de silicium ou une résine organique par exemple photosensible.

13. Cellule photovoltaïque selon l'une des revendications 11 et 12, **caractérisé en ce que** le matériau électriquement conducteur est de l'argent, du cuivre, du nickel, de l'étain ou un de leurs alliages.

14. Cellule photovoltaïque selon l'une quelconque des revendications 11 à 13, **caractérisé en ce que** la surface de la zone (9) est comprise entre 0,1 fois et 10 fois la largeur au carré de la première ligne (4).

15. Cellule photovoltaïque selon l'une quelconque des revendications 11 à 14, **caractérisé en ce que** la largeur de la première ligne (4) est comprise entre 5µm et 100µm et la largeur de la deuxième ligne (5) est comprise entre 0.1mm et 1.5mm.

## Patentansprüche

1. Verfahren zur Herstellung von mindestens einem elektrischen Kontakt (8) durch elektrochemisches Auftragen eines elektrisch leitenden Werkstoffs auf einer Seite einer Fotozelle (1), wobei der genannte Kontakt von einem ersten (4) und einem zweiten (5) Band gebildet wird, die miteinander verbunden sind, wobei das zweite Band (5) eine Breite aufweist, die größer ist als die Breite des ersten Bandes (4),
**dadurch gekennzeichnet,**
**dass** es vor dem elektrochemischen Auftragen einen Verfahrensschritt des Bildens mindestens eines Bereichs (9) mit einer elektrischen Leitfähigkeit, die geringer ist als die elektrische Leitfähigkeit des elektrisch leitenden Werkstoffs, auf einem Teil der Seite der Fotozelle (1) enthält, der dazu vorgesehen ist, elektrisch mit dem zweiten Band (5) im Bereich seiner Schnittfläche (10) mit dem ersten Band (4) gekoppelt zu werden.

2. Verfahren nach Anspruch 1,
**dadurch gekennzeichnet,**
**dass** der Bereich (9) aus einem elektrisch isolierenden Werkstoff wie z. B. Siliziumnitrid, Siliziumoxid oder organischen Harzen, die zum Beispiel fotoempfindlich sind, gebildet wird.

3. Verfahren nach einem der Ansprüche 1 und 2,
**dadurch gekennzeichnet,**
**dass** der Bereich (9) in der Form eines Pföstchens mit insbesondere einem quadratischen, rechtwinkligen oder kreisförmigen Querschnitt besteht.

4. Verfahren nach einem der Ansprüche 1 bis 3,
**dadurch gekennzeichnet,**
**dass** es vor dem Verfahrensschritt des elektrochemischen Auftragens einen Verfahrensschritt des Bildens einer Maske (7) aus einem elektrisch isolierenden Werkstoff wie z. B. Siliziumnitrid, Siliziumoxid oder organischen Harzen, z. B. fotoempfindlichen organischen Harzen auf der genannten Seite der Fotozelle enthält, wobei diese Maske Öffnungen enthält, die ein Muster bilden, das dem des elektrischen Kontakts entspricht.

5. Verfahren nach Anspruch 4,
**dadurch gekennzeichnet,**
**dass** die Maske durch Fotolithographie, durch Serigraphie oder durch Auftragen einer Schicht aus elektrisch isolierendem Werkstoff auf die der Seite der Fotozelle und Anwendung eines Laserstrahls auf die Oberfläche dieser Schicht zur Bildung der Öffnungen in der Schicht hergestellt wird.

6. Verfahren nach einem der Ansprüche 4 und 5,
**dadurch gekennzeichnet,**
**dass** die Maske (7) entfernt wird, sobald das elektrochemische Auftragen ausgeführt ist.

7. Verfahren nach einem der Ansprüche 4 bis 6,
**dadurch gekennzeichnet,**
**dass** der Bereich (9) von einem Teil dieser Maske (7) gebildet wird.

8. Verfahren nach einem der Ansprüche 4 bis 7,
**dadurch gekennzeichnet,**
**dass** ein Verfahrensschritt des Auftragens einer Metallschicht (11) vor dem elektrochemischen Auftragen ausgeführt wird, um das elektrochemische Auftragen zu beschleunigen.

9. Verfahren nach Anspruch 8,
**dadurch gekennzeichnet,**
**dass** die Metallschicht (11) vor der Herstellung der Maske (7) über die Gesamtheit der Seite der Fotozelle gebildet wird.

10. Verfahren nach Anspruch 8,
**dadurch gekennzeichnet,**
**dass** die Metallschicht (11) auf den Verfahrensschritt der Herstellung der Maske (7) folgend in den Öffnungen dieser Maske (7) gebildet wird.

11. Fotozelle (1), die auf mindestens einer Seite mit einem elektrischen Kontakt (8) aus einem elektrisch leitenden Werkstoff versehen ist, der von einem ersten (4) und einem zweiten (5) Band gebildet wird, die miteinander verbunden sind, wobei das zweite Band (5) eine Breite aufweist, die größer ist als die Breite des ersten Bandes (4),
**dadurch gekennzeichnet,**
**dass** das zweite Band (5) zumindest in einem Teil seiner Dicke und im Bereich der Schnittfläche (10) der Bänder einen Bereich (9) mit einer geringeren Leitfähigkeit als der des elektrisch leitenden Werkstoffs enthält.

12. Fotozelle nach Anspruch 11,
**dadurch gekennzeichnet,**
**dass** der Bereich (9) aus einem elektrisch isolierenden Werkstoff, insbesondere aus Siliziumnitrid, Siliziumoxid oder einem organischen Harz, das beispielsweise fotoempfindlich ist, besteht.

13. Fotozelle nach einem der Ansprüche 11 und 12,
**dadurch gekennzeichnet,**
**dass** der elektrisch leitende Werkstoff Silber, Kupfer, Nickel, Zinn oder eine von deren Legierungen ist.

14. Fotozelle nach einem der Ansprüche 11 bis 13,
**dadurch gekennzeichnet,**
**dass** die Oberfläche des Bereichs (9) das 0,1-fache bis 10-fache der Breite im Quadrat des ersten Bandes (4) beträgt.

15. Fotozelle nach einem der Ansprüche 11 bis 14,
**dadurch gekennzeichnet,**
**dass** die Breite des ersten Bandes (4) 5*µ*m bis 100*µ*m beträgt und die Breite des zweiten Bandes (5) 0,1 mm bis 1,5mm beträgt.

## Claims

1. A method for producing at least one electric contact (8) by electrochemical deposition of an electrically conducting material on a face of a photovoltaic cell (1), said contact being formed by first (4) and second (5) lines connected to one another, the second line (5) presenting a larger width than the width of the first line (4),
**characterized in that** it comprises, before electrochemical deposition, a formation step of at least one area (9) presenting a lower electric conductivity than the electric conductivity of the electrically conducting material, on a part of the face of the photovoltaic cell (1) designed to be electrically connected with the second line (5), at the level of its intersection (10) with the first line (4).

2. The method according to claim 1, **characterized in that** the area (9) is formed by an electrically insulating material such as silicon nitride, silicon oxide or organic resins which are for example photosensitive.

3. The method according to one of claims 1 and 2, **characterized in that** the area (9) is in the form of a pillar having in particular a square, rectangular or circular cross-section.

4. The method according to any one of claims 1 to 3, **characterized in that** it comprises, before the electrochemical deposition step, a formation step of a mask (7) made from electrically insulating material such as silicon nitride, silicon oxide or organic resins which are for example photosensitive, on said face of the photovoltaic cell, said mask comprising openings forming a pattern corresponding to that of the electric contact.

5. The method according to claim 4, **characterized in that** the mask is formed by photolithography, by screen printing or by deposition of a layer of electrically insulating material on the face of the photovoltaic cell and application of a laser beam on the face of said layer to form the openings in the layer.

6. The method according to one of claims 4 and 5, **characterized in that** the mask (7) is removed once electrochemical deposition has been performed.

7. The method according to any one of claims 4 to 6, **characterized in that** the area (9) is formed by a part of said mask (7).

8. The method according to any one of claims 4 to 7, **characterized in that** a deposition step of a metallic layer (11) is performed before electrochemical deposition to activate the electrochemical deposition.

9. The method according to claim 8, **characterized in that** the metallic layer (11) is formed on the whole of the face of the photovoltaic cell, before formation of the mask (7).

10. The method according to claim 8, **characterized in that** the metallic layer (11) is formed subsequent to the formation step of the mask (7) in the openings of said mask (7).

11. A photovoltaic cell (1) provided on at least one face with an electric contact (8) made from electrically conducting material and formed by first (4) and second (5) lines connected to one another, the second line (5) presenting a larger width than the width of the first line (4),
**characterized in that** the second line (5) comprises, at least in a part of its thickness and at the level of the intersection (10) of the lines, an area (9) having a lower conductivity than that of the electrically conducting material.

12. The photovoltaic cell according to claim 11, **characterized in that** the area (9) is made from electrically insulating material, in particular silicon nitride, silicon oxide or an organic resin which can for example be photosensitive.

13. The photovoltaic cell according to one of claims 11 and 12, **characterized in that** the electrically conducting material is silver, copper, nickel, tin or one of their alloys.

14. The photovoltaic cell according to any one of claims 11 to 13, **characterized in that** the surface of the area (9) is comprised between 0.1 times and 10 times the squared width of the first line (4).

15. The photovoltaic cell according to any one of claims 11 to 14, **characterized in that** the width of the first line (4) is comprised between 5µm and 100µm and the width of the second line (5) is comprised between 0.1mm and 1.5mm.
